# EUROPEAN PATENT APPLICATION

(11) **EP 1 283 549 A1**
(43) Date of publication of application: **12.02.2003**
(21) Application number: 01830516.9
(22) Date of filing: 02.08.2001
(51) Int. Cl.: H01L 21/784, H01L 21/304, H01L 21/463, H01L 21/78, H01L 23/31, H01L 29/36, H01L 27/10

(54) **Semiconductor device with mechanical stress protection during wafer cutting, and manufacturing process thereof**

(71) Applicant: STMicroelectronics S.r.l., 20041 Agrate Brianza (Milano) (IT)
(72) Inventor: Pividori, Luca, 24035 Curno (IT)
(74) Representative: Franzolin, Luigi

(57) **Abstract**

A semiconductor device including an electronic component (12) and an edge region (42) delimited by a side surface (41). The device is formed in a substrate (11) of semiconductor material overlaid by a plurality of superficial layers (13-16, 20-24) which form, on top of the edge region, a stack of insulating layers (30). A first groove (31) extends in the stack of insulating layers (30), near the electronic component (12). A second groove (32) extends in the stack of insulating layers (30) between the first groove and the side surface and operates as an element of mechanical decoupling which blocks any possible delayering of the superficial layers during cutting of the wafer.

## Description

The present invention relates to a semiconductor device with mechanical stress protection during wafer cutting, and to the manufacturing process thereof.

As is known, in the manufacture of semiconductor devices, a plurality of devices is formed in a same wafer, which is then cut into single dice in a final manufacturing step. For this purpose, in the areas where the wafers are to be cut, referred to as scribing lines, the substrate of the wafer is laid bare by removing the various superficial layers (dielectric interlayers, conductive layers, passivation layers).

The removal of these layers from the regions to be cut entails, however, a number of problems linked to the lack of planarity of the surface, which may cause incomplete removal of some layers. In this case, the undesired remaining portions can be removed subsequently using special etches, but frequently, during these etches, the particles removed adhere to the surface of the wafer or of the die, reducing the quality of the devices and the manufacturing yield.

To solve this problem, it has been proposed to keep some of the dielectric layers, so as to reduce the difference in height between the regions to be cut and the device and in order to form grooves between the region to be cut and the active areas of the device, at on-board structures.

Notwithstanding this, the mechanical stresses generated during the cutting operation may propagate within the substrate and over its surface. In-depth propagation within the substrate (referred to as "chipping") largely depends upon the thickness at which the wafers are polished and generally decreases as the polishing thickness decreases. Surface propagation (referred to as "cracking") instead involves the dielectric and passivation layers of the devices and directly vitiates integrity of the latter.

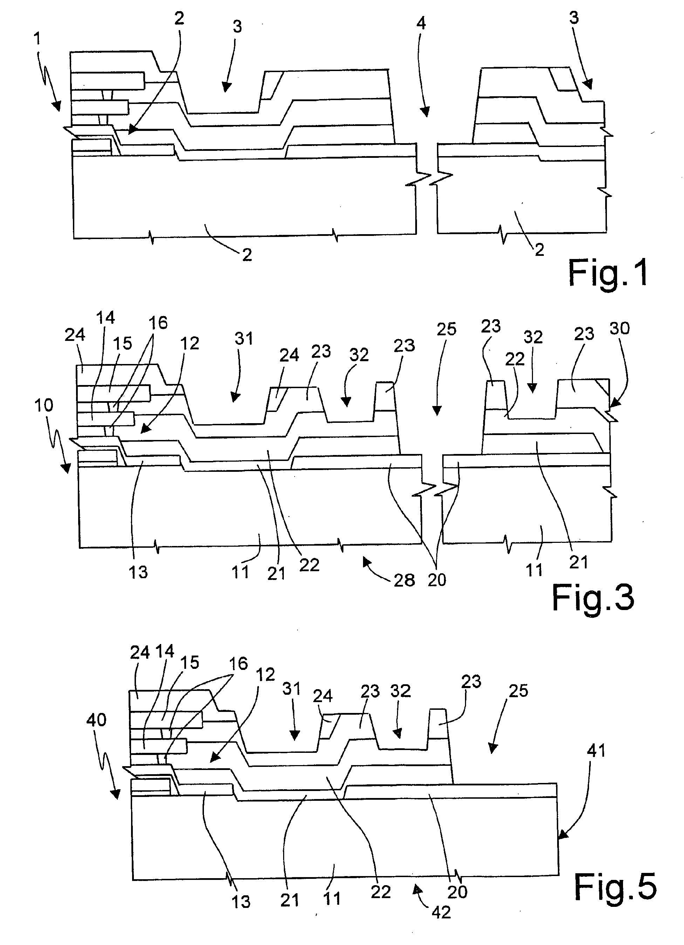

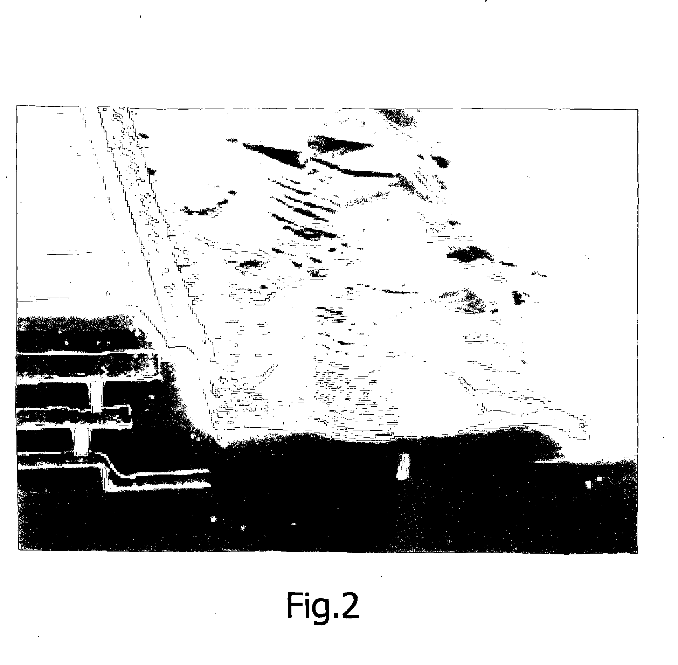

Figure 1 shows a cross-section of a portion of a wafer 1 of semiconductor material housing an MOS component 2 having three metal levels. Figure 1 shows a groove 3 on either side of the scribing line 4. Figure 2 shows the photograph of the cross-section of the device of Figure 1 after cutting. As may be noted from a comparison between Figure 1 and Figure 2, the stresses caused by the cut have led to delayering of the protective layers, which have in part detached, so that the original groove is no longer visible. In this situation, the component 2 risks getting damaged and/or not being sufficiently protected from infiltrations.

The aim of the present invention is provide a manufacturing process that reduces the risk of propagation of stresses during the cutting step.

According to the present invention there are provided a semiconductor device, a semiconductor material wafer, and a method for manufacturing a semiconductor device, as defined in Claims 1, 6, and 7, respectively.

For a better understanding of the present invention, an embodiment thereof is now described, purely by way of non-limiting example, with reference to the attached drawings, wherein:
- Figure 1 illustrates a cross-section of a semiconductor material wafer of a known type, before cutting;
- Figure 2 shows, in a perspective view, the photograph, taken using a SEM, of the cross-section of the known device after cutting the wafer of Figure 1;
- Figure 3 shows a cross-section of a semiconductor material wafer according to the invention;
- Figure 4 is a top plan view of the wafer of Figure 3; and
- Figure 5 is a cross-sectional view of a device obtained after cutting the wafer of Figure 3.

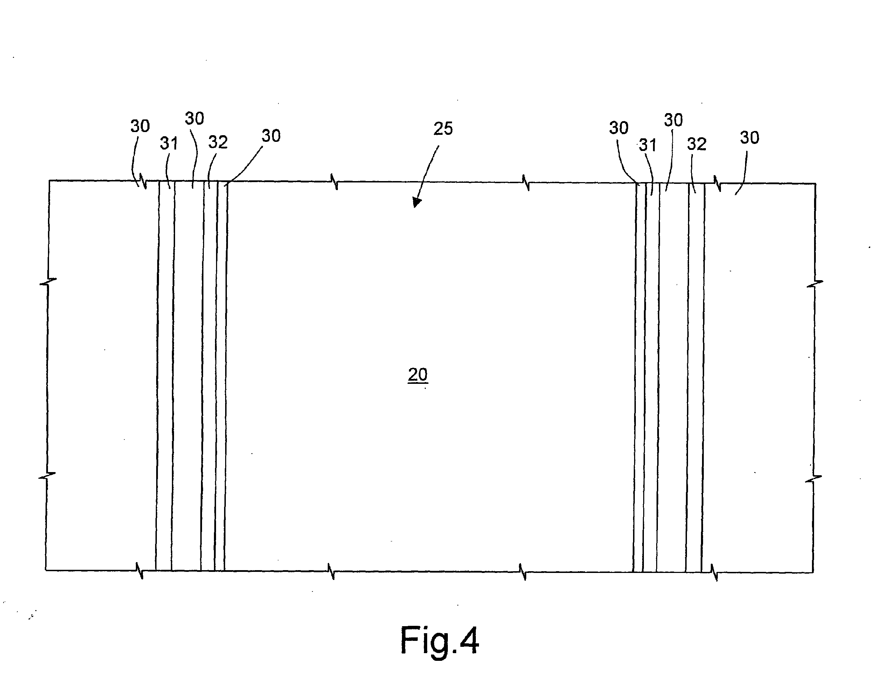

Figure 3 shows a wafer 10 comprising a substrate 11 and a plurality of superficial layers defining a component 12 (here an MOS transistor), and various metal levels. In particular, in Figure 3 there may be seen a first metal level 13, a second metal level 14, and a third metal level 15, which are connected together through plugs 16. A first insulating layer 20 covers the substrate 11 in separation areas 28 which extend between adjacent devices. A second insulating layer 21 and a third insulating layer 22 extend between the first metal level 13 and the second metal level 14. A fourth insulating layer 23 extends between the second metal level 14 and the third metal level 15. A passivation layer 24 covers the entire wafer 10.

The insulating layers 20-23 and the passivation layer 24 are directly overlaid in the separation area 28 and form a stack 30 of insulating layers.

The second, third and fourth insulating layers 21-23 and the passivation layer 24 are removed at a scribing line 25, at the center of the separation area 28. In addition, the stack 30 has two grooves 31, 32 which extend on either side of the scribing line 25.

In particular, a first groove 31, conceptually corresponding to the groove 3 of Figure 1, is formed on an edge region 42 of each component 12, near the component 12 itself. A second groove 32 is formed between the first groove 31 and the scribing line 25, on the first insulating layer 20. A corresponding pair of grooves 31, 32 is made on the other side (the right-hand side in the figure) of the scribing line 25.

By way of non-limiting example, the first grooves 31 have standard dimensions (e.g., 5 µm), and the second grooves 32 have a width of between 2 and 3 µm (in the example shown, 3 µm). Advantageously, the first groove and the second groove are set apart by at least 1 µm, preferably at least 2 µm (in the example illustrated, 5 µm). In general, the first and second grooves 31, 32 follow the shape of the scribing line 25, as may be seen in the layout of Figure 4.

Consequently, when the wafer 10 is cut at the scribing line 25, the second groove 32 operates, in addition to the first groove 31, as an element of mechanical decoupling between the scribing line 25 and the component 12, and hence contributes to preventing propagation of delayering of the layers of the stack 30 in the direction of the devices, and in this way increases the efficacy of the first groove 31.

The wafer 10 of Figure 3 is manufactured adopting initially the customary manufacturing steps up to the deposition of the passivation layer 24. When the passivation layer 24 is finally etched out to lay bare the contact pads (not illustrated), using the same PAD mask the passivation layer 24 and the third and fourth insulating layers 22, 23 are removed. The first groove 31 and the second groove 32 are advantageously formed simultaneously. In addition, the grooves 31, 32 may be formed either simultaneously with or before or after the scribing line 25.

After cutting (Figure 5), each electronic device 40 is delimited by a side surface 41 and comprises the component 12 and the edge region 42 (made up of approximately one half of the separation area 28), including both the grooves 31, 32. The second groove 32 is set between the first groove 31 and the remaining portion of the scribing line 25. Only in certain particular cases of delayering of the material, the second groove 32 may be no longer completely visible.

Finally, it is clear that modifications and variations may be made to the device and manufacturing process described herein, without thereby departing from the scope of the present invention, as defined in the attached claims.

For example, the second groove 32 can be formed by etching one or more passivation layers and/or intermediate-insulation layers, in any passivation step, until the substrate 11 is completely uncovered, or leaving some of the insulating layers 20-23.

## Claims

1. A semiconductor device including an electronic component (12) and an edge region (42) delimited by a side surface (41), the device comprising a substrate (11) of semiconductor material and a plurality of superficial layers (13-16, 20-24) forming, on top of said edge region, a stack of insulating layers (30), a first groove (31) extending in said stack of insulating layers (30), said device being **characterized by** a second groove (32) formed in said stack of insulating layers (30) between said first groove and said side surface.

2. The semiconductor device according to Claim 1, wherein said second groove (32) has a width of between 2 and 5 µm.

3. The semiconductor device according to Claim 1 or 2, wherein said second groove (32) is set apart from said first groove (31) by at least 1 µm, preferably 2 µm.

4. The semiconductor device according to any of Claims 1 to 3, wherein said second groove is comprised between said first groove (31) and a scribing line (25) adjacent to said side surface (41).

5. The semiconductor device according to any of the foregoing claims, **characterized in that** said first groove (31) and said second groove (32) extend parallel to one another and substantially parallel to said side surface (41).

6. A wafer of semiconductor material including electronic components (12) each of which is surrounded by a respective edge region (42) and which are separated by scribing lines (25), the wafer comprising a substrate (11) of semiconductor material and a plurality of superficial layers (13-16, 20-24) forming, on top of said edge regions, stacks of insulating layers (30), first grooves (31) extending in said stacks of insulating layers (30) at the sides of said scribing lines, said wafer being **characterized by** second grooves (32) formed in said stacks of insulating layers (30) between each of said first grooves and each of said scribing lines.

7. A process for manufacturing a semiconductor device, comprising the steps of:
forming, on a substrate (11) of semiconductor material, a plurality of superficial layers (13-16, 20-24) defining electronic components (12) delimited by a respective edge region (42), said superficial layers forming, on top of said edge regions, stacks of insulating layers (30);
forming scribing lines (25) between edge regions (42) of adjacent components;
forming first grooves (31) in said stacks of insulating layers (30), at the sides of said scribing lines; and
forming second grooves (32) in said stacks of insulating layers (30) between each of said first grooves and each of said scribing lines.

8. The process according to Claim 7, wherein said steps of forming first grooves and forming second grooves are carried out simultaneously.

9. The process according to Claim 7 or 8, **characterized by** the steps of depositing said superficial layers and removing portions of said superficial layers from above said edge regions.

10. The process according to Claim 9, **characterized in that** said step of removing comprises etching said insulating layers using a PAD mask.
